# EUROPEAN PATENT APPLICATION

(11) **EP 3 863 043 A1**
(43) Date of publication of application: **11.08.2021**
(21) Application number: 19868808.7
(22) Date of filing: 30.09.2019
(51) Int. Cl.: H01L 21/683, C23C 16/458, H01L 21/205

(54) **SUSCEPTOR**

(30) Priority: 04.10.2018 JP 2018188952
(71) Applicant: Toyo Tanso Co., Ltd., Osaka-shi, Osaka 555-0011 (JP)
(72) Inventor: IKEJIRI, Takahiro, Kanonji-shi, Kagawa 769-1612 (JP)
(74) Representative: TBK
(86) International application number: PCT/JP2019/038492
(87) International publication number: WO 2020/071308

(57) **Abstract**

Provided is a susceptor which enables improvement in yield of semiconductor chips produced from wafers, has a long life, and hardly causes chipping. The susceptor includes pockets (2) in which wafers (10) are to be placed, wherein at least one of the pockets (2) includes a plurality of supporting portions (3) for supporting the wafer (10), a plurality of contact portions (4) to make contact with a lateral surface (10a) of the wafer (10), and a plurality of non-contact portions (5) spaced from the lateral surface (10a) of the wafer (10). The contact portions (4) and the non-contact portions (5) are alternately provided in the inner peripheral wall of the pocket (2), and at least two of the supporting portions (3) are provided on lines extending from a center (O) of the pocket (2) to the non-contact portions (5) when the susceptor is viewed from above.

## Description

### Technical Field

The present invention relates to a susceptor which is used in manufacturing a semiconductor.

### Background Art

In order to manufacture good LEDs, for example, it is important to carry out uniform epitaxial growth of thin film crystalline layers which are to be stacked on a surface of a wafer, which will serve as a semiconductor chip. For this reason, a susceptor which is used in manufacturing a semiconductor needs to achieve uniform heating by applying conductive heat and radiant heat to the wafer in order to carry out epitaxial growth to form thin film crystalline layers of uniform film thickness. However, to the wafer placed in a pocket of the susceptor, the conductive heat is applied through a portion making contact with the pocket, and therefore a temperature of the wafer tends to become uneven between an outer peripheral portion which is in contact with the pocket and a central portion which is not in contact with the pocket. Specifically, a region of approximately 3 mm from an outer periphery to an inside of the wafer tends to have different temperatures, and this causes a lower yield of semiconductor chips.

Under the circumstances, various proposals have been made on a shape of the pocket (e.g., a wafer carrier (susceptor) disclosed in Patent Literature 1).

### Citation List

### [Patent Literature]

[Patent Literature 1]
Japanese Patent Application Publication Tokukai No. 2013-138224

### Summary of Invention

### Technical Problem

However, as a result of the study by the inventors of the present invention, it has been found that, in the wafer carrier disclosed in Patent Literature 1, a supporting portion which supports the wafer placed in the pocket abuts on a contact portion which is in contact with a lateral surface of the wafer, and therefore the conductive heat tends to be locally applied to the wafer. On the basis of the above finding, it has been found, as a problem, that a temperature difference occurs in the wafer between the outer peripheral portion which is in contact with the pocket and the central portion which is not in contact with the pocket, and this leads to a lower yield of semiconductor chips.

Moreover, the susceptor is rotated in manufacturing semiconductors. Therefore, if a contact area between the susceptor and the wafer is too small, a stress caused by centrifugal force is concentrated on the contact area (collision area) with the wafer placed in the pocket when the susceptor is rotated during various processes. Therefore, the wafer carrier (susceptor) disclosed in Patent Literature 1 has been found to have a problem that chipping may occur in the susceptor and the wafer at the contact area.

An objective of an aspect of the present invention is to provide a susceptor which makes it possible to improve a yield of semiconductor chips produced from wafers. Another objective of an aspect of the present invention is to provide a susceptor which has a long life and with which chipping is less likely to occur.

### Solution to Problem

In order to attain the objectives, the present invention encompasses the features described in the following <1> through <3>:
<1> A susceptor including at least one pocket in which a wafer is to be placed, in which: the at least one pocket includes a plurality of supporting portions which is to support a wafer, a plurality of contact portions which are to make contact with a lateral surface of the wafer, and a plurality of non-contact portions which are not to make contact with the lateral surface of the wafer; the plurality of contact portions and the plurality of non-contact portions are alternately provided in an inner peripheral wall of the at least one pocket; and at least two of the plurality of supporting portions are respectively disposed on lines extending from a center of the at least one pocket to the plurality of non-contact portions when the susceptor is seen from above.
<2> The susceptor described in <1>, in which a length of each of the plurality of contact portions is 2 mm or more in a circumferential direction.
<3> The susceptor described in <1> or <2>, in which a total length of the plurality of contact portions in the circumferential direction accounts for 1.5% to 50% of a circumference of the at least one pocket.

### Advantageous Effects of Invention

According to an aspect of the present invention, in the susceptor, the plurality of contact portions and the plurality of non-contact portions are alternately provided in the inner peripheral wall of the pocket, and at least two of the plurality of supporting portions are respectively disposed on the lines extending from the center of the pocket to the plurality of non-contact portions when the susceptor is seen from above. With the configuration, a temperature difference is hardly generated in the wafer between the outer peripheral portion which is in contact with the pocket and the central portion which is not in contact with the pocket, and this leads to an improvement in quality. Therefore, it is possible to bring about an effect of providing the susceptor which makes it possible to improve a yield of semiconductor chips produced from wafers. Moreover, the plurality of contact portions and the plurality of non-contact portions are alternately provided in the inner peripheral wall of the pocket, and this reduces concentration of a stress, which is caused by centrifugal force, on the contact area (collision area) with the wafer placed in the pocket. Therefore, it is possible to bring about an effect of providing the susceptor which has a long life and with which chipping is less likely to occur in the susceptor and the wafer.

### Brief Description of Drawings

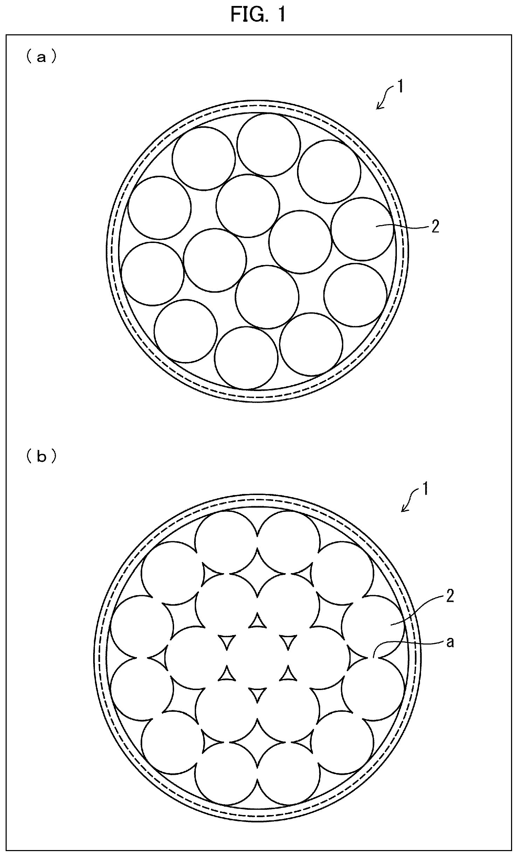

Each of (a) and (b) of Fig. 1 is a plan view schematically illustrating an example of a susceptor in accordance with an embodiment of the present invention.
Fig. 2 is a diagram illustrating one of pockets provided in the susceptor (Example 1, Comparative Examples 1 and 2). (a) of Fig. 2 is a plan view schematically illustrating the pocket, and (b) of Fig. 2 is a cross-sectional view taken along the line A-A in (a) of Fig. 2.
Fig. 3 is a diagram illustrating main parts of the pocket (Example 1). Each of (a) through (c) of Fig. 3 is a plan view schematically illustrating a supporting portion, and each of (d) through (f) of Fig. 3 is a cross-sectional view schematically illustrating a contact portion.
Fig. 4 is a diagram illustrating Modification Examples and Example 2 of the pocket in accordance with another embodiment of the present invention. (a) of Fig. 4 is a plan view schematically illustrating the pocket, and (b) of Fig. 4 is a cross-sectional view taken along the line A-A in (a) of Fig. 4.

### Description of Embodiments

The following description will discuss embodiments of the present invention. The present invention is, however, not limited to the embodiments below. The present invention is not limited to embodiments and arrangements described below, but may be altered in various ways by a skilled person within the scope of the claims. The present invention also encompasses, in its technical scope, any embodiment and any working example derived by appropriately combining technical means disclosed in differing embodiments and differing working examples. Moreover, all scientific literatures and patent literatures described in this specification are incorporated herein as reference literatures. Note that numerical expressions such as "A to B" herein mean "not less than A and not more than B" unless otherwise stated.

### Embodiment 1

The following description will discuss an embodiment of the present invention.

A susceptor in accordance with an embodiment of the present invention is a susceptor including at least one pocket in which a wafer is to be placed, in which: the at least one pocket includes a plurality of supporting portions which is to support a wafer, a plurality of contact portions which are to make contact with a lateral surface of the wafer, and a plurality of non-contact portions which are not to make contact with the lateral surface of the wafer; the plurality of contact portions and the plurality of non-contact portions are alternately provided in an inner peripheral wall of the at least one pocket; and at least two of the plurality of supporting portions are respectively disposed on lines extending from a center of the at least one pocket to the plurality of non-contact portions when the susceptor is seen from above.

As illustrated in Fig. 1, a disk-shaped susceptor (also referred to as "pedestal", "substrate support", "wafer carrier" or the like) 1 is a member to be attached to a manufacturing device such as an MOCVD device used in manufacturing semiconductors. The susceptor is made of a carbon-based material such as high-purity isotropic graphite or a silicon carbide sintered body. Specifically, for example, a suitable susceptor is a susceptor in which a surface of high-purity isotropic graphite is coated with SiC. A diameter of the susceptor 1 is not particularly limited because the diameter is appropriately set in accordance with the device for manufacturing semiconductors.

The susceptor 1 is used as follows. In a semiconductor manufacturing process, a semiconductor wafer (hereinafter, simply referred to as "wafer") such as a sapphire wafer, a gallium nitride wafer, or a silicon wafer is placed on the susceptor 1, then the susceptor 1 is rotated horizontally while being heated, and thin film crystalline layers are epitaxially grown and stacked on a surface of the wafer. The susceptor 1 is also used in surface modification to form an oxide layer or a nitride layer on a surface of a wafer, in surface cleaning to remove contaminants attached to the surface of the wafer, or in annealing.

At least one pocket or a plurality of pockets (also referred to as "recessed portion", "counterbore" or the like) 2 are provided on an upper surface of the susceptor 1, and various processes are carried out with respect to wafers placed in the respective pockets 2. Below the susceptor 1, a heating device (not illustrated) such as a heater or a high-frequency induction coil for heating the susceptor 1 is provided. According to the susceptor 1, the number and arrangement of the pockets 2 and the arrangement of the heating device are determined so that heating can be carried out uniformly on all wafers placed on the susceptor 1. The number and arrangement of the pockets 2 are not particularly limited, and can be determined in accordance with sizes of the susceptor 1 and of the wafer so that the pockets 2 are provided as many as possible. The number, arrangement and size of the pockets 2 provided in the susceptor 1 illustrated in Fig. 1 are therefore merely examples.

A diameter (φ) of the pocket 2 refers to a diameter of an inner peripheral wall where contact portions 4 are provided (i.e., not a diameter of the inner peripheral wall where non-contact portions 5 are provided). Assuming that the diameter of the pocket 2 is 100, a smallest diameter of a wafer 10 placed in the pocket 2 is typically 98 or more and less than 100. If the diameter of the wafer 10 is less than 98, chipping due to collision may tend to occur in the susceptor 1 and the wafer 10 when rotation of the susceptor 1 starts, ends, and the like. The term "inner peripheral wall" simply described in this specification refers to the inner peripheral wall where the contact portions 4 are provided.

Each of the plurality of pockets 2 has a substantially circular shape when the susceptor 1 is viewed from above. The plurality of pockets 2 can be provided independently of each other as illustrated in (a) of Fig. 1, and can be provided so as to communicate with each other as illustrated in (b) of Fig. 1. The pockets 2 are formed while adjusting the depth (i.e., deeper or shallower) for each pocket 2, in view of flows and temperature distribution of gases in a state where wafers are placed.

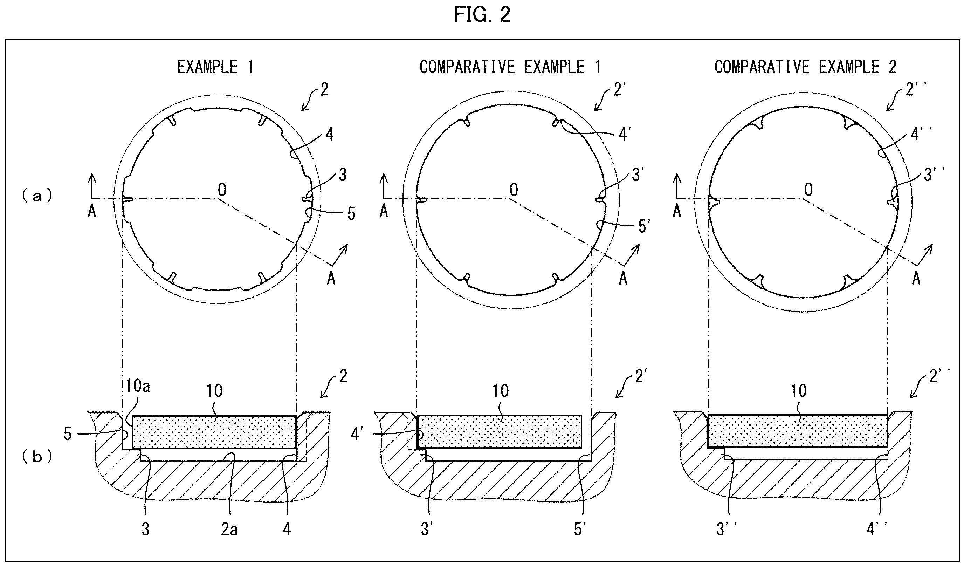

The case where the pockets 2 are provided independently of each other will be further described as an example. As illustrated in Fig. 2 as Example 1, at least one of the pockets 2 includes: a plurality of supporting portions 3 which is to support the wafer 10; a plurality of contact portions 4 which are to make contact with a lateral surface 10a of the wafer 10; and a plurality of non-contact portions 5 which are not to make contact with the lateral surface 10a of the wafer 10. The contact portions 4 and the non-contact portions 5 are alternately provided in the inner peripheral wall of the pocket 2, and at least two of the supporting portions 3 are respectively provided on lines extending from a center O of the pocket 2 to the non-contact portions 5 when the susceptor 1 is viewed from above. The number and arrangement of the supporting portions 3, the contact portions 4, and the non-contact portions 5 are not particularly limited and can be appropriately determined in accordance with a position where the pocket 2 is provided in the susceptor 1, a position of the heating device, and the like. Thus, the pocket 2 (Example 1) illustrated in Fig. 2, in which six supporting portions 3, six contact portions 4, and six non-contact portions 5 are equally spaced, is merely an example.

The plurality of supporting portions (also referred to as "tabs") 3 are provided in one susceptor 1 so as to make contact with a lower surface of the wafer 10 to support the wafer 10 placed in the pocket 2. The number of supporting portions 3 is not particularly limited, provided that the number is at least three so as to stably support the wafer 10 placed thereon. A height of the supporting portion 3 from a bottom surface 2a of the pocket 2 only needs to be a height with which radiant heat from the bottom surface 2a is moderately applied to the wafer 10 in view of warpage of the wafer 10. The height of the supporting portion 3 can be, for example, in a range of 0.02 mm to 1.5 mm, preferably in a range of 0.02 mm to 0.5 mm. However, the height of the supporting portion 3 from the bottom surface 2a of the pocket 2 is not particularly limited, provided that the wafer 10 and the bottom 2a do not make contact with each other. A contact area of the supporting portion 3 with the wafer 10 is not particularly limited, provided that the wafer 10 is stably supported by the supporting portion 3 and conductive heat which is from the supporting portion 3 is reduced as much as possible.

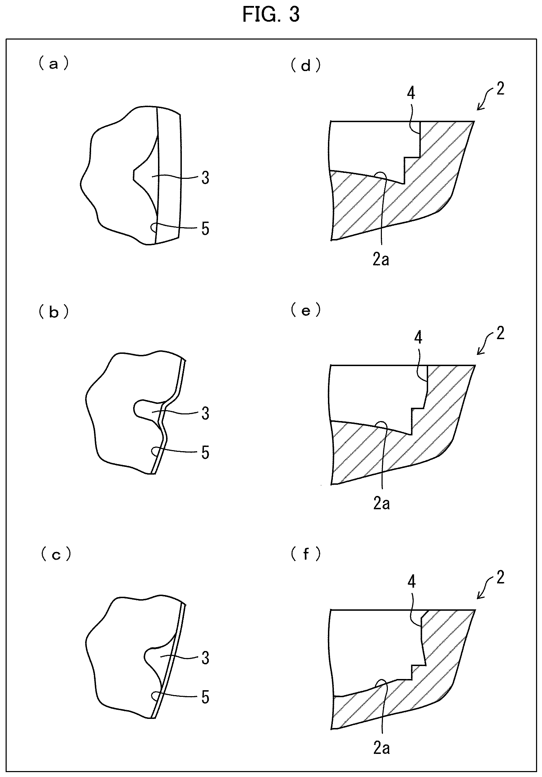

A shape of the supporting portion 3 (i.e., the shape when the pocket 2 is viewed from above) is not particularly limited, and the shape can be any of various shapes such as a mountain-like shape as illustrated in (a) through (c) of Fig. 3. In each of (a) through (c) of Fig. 3, the supporting portion 3 protrudes from the bottom surface 2a and makes contact with the non-contact portion 5. However, the supporting portion 3 can be provided, in the pocket 2, at a position which is adjacent to a position at which the non-contact portion 5 is provided, without making contact with the non-contact portion 5. That is, at least two of the supporting portions 3, particularly preferably all of the plurality of supporting portions 3, only need to be provided on lines extending from the center O of the pocket 2 to the non-contact portions 5 when the susceptor 1 is viewed from above, and do not need to be in contact with the non-contact portions 5. The supporting portion 3 may not be located at a middle part of the non-contact portion 5 when the susceptor 1 is viewed from above.

The contact portion 4 is included in the inner peripheral wall of the pocket 2 and makes contact (preferably surface contact) with the lateral surface 10a of the wafer 10 at least when the susceptor 1 is rotated. That is, in the pocket 2, the contact portion 4 and the lateral surface 10a of the wafer 10 placed in the pocket 2 are in contact (preferably, surface contact) with each other. Here, the term "surface contact" includes a state of substantially being in surface contact with each other. Specifically, the term indicates a state in which a shortest distance between (i) any point of the contact portion 4 which is to make contact with the wafer 10 and (ii) the lateral surface 10a of the wafer 10 placed in the pocket 2 is zero (i.e., the contact portion 4 is in physical contact with the lateral surface 10a of the wafer 10) to 2% or less, preferably 1% or less, with respect to the diameter of the pocket 2 (i.e., the diameter of the inner peripheral wall where the contact portions 4 are provided). Thus, the contact portion 4 does not need to entirely make physical contact with the lateral surface 10a of the wafer 10.

A length of one contact portion 4 in a circumferential direction (i.e., a length in the circumferential direction when the pocket 2 is viewed from above) is preferably 2 mm or more in order to reduce concentration of stress caused by centrifugal force on the contacting portion of the wafer 10. The number of contact portions 4 and the length in the circumferential direction of each of the contact portions 4 are not particularly limited, and can be set so that the temperatures of the wafer 10 can be made uniform. Further, a total length of the plurality of contact portions 4 in the circumferential direction preferably accounts for 1.5% to 50% of a circumference (i.e., a circumference of a circle where the contact portions 4 are provided) of the pocket 2.

In the pocket 2, a cross-sectional shape of the inner peripheral wall where the contact portion 4 is provided can vertically extend upward from the bottom surface 2a as illustrated in (d) of Fig. 3, can be inclined so as to spread upward from the bottom surface 2a as illustrated in (e) of Fig. 3, and can be inclined so as to narrow upward from the bottom surface 2a as illustrated in (f) of Fig. 3. Note that an angle of the inclination is preferably approximately -10° to 10°, where the state in which the inner peripheral wall vertically extends upward from the bottom surface 2a is defined as 0°.

The non-contact portion 5 is provided, in the inner peripheral wall of the pocket 2, at a position which is adjacent to a position at which the supporting portion 3 is provided. Therefore, the contact portion 4 is not provided in an area where the supporting portion 3 is provided. As such, in the pocket 2, the supporting portion 3 does not abut on the contact portion 4, so that the conductive heat is not locally applied to the wafer 10.

The non-contact portion 5 is spaced from the wafer 10 so that conductive heat from the non-contact portion 5 will not affect the wafer 10. That is, the non-contact portion 5 can be provided at a position farther from the center O of the pocket 2 as compared with the contact portion 4.

In order to divide the contact portion 4 or the like, the non-contact portion 5 can be provided at a position that is not adjacent to a position at which the supporting portion 3 is provided (i.e., the non-contact portion 5 can be provided in an area where the supporting portion 3 is not provided), according to need. Further, as illustrated in (b) of Fig. 1, in a case where the plurality of pockets 2 communicate with each other, a communication portion a also corresponds to the non-contact portion, and the supporting portion 3 may not be provided in the communication portion a.

The pocket 2 only needs to have a plurality of regions in each of which the supporting portion 3, the contact portion 4, and the non-contact portion 5 are provided in the arrangement in accordance with Embodiment 1. That is, the pocket 2 in accordance with Embodiment 1 can have a region in which the supporting portion, the contact portion, and the non-contact portion are provided in a conventional arrangement. Further, in a case where the plurality of pockets 2 are provided in the susceptor 1, the susceptor 1 only needs to include at least one pocket 2 in accordance with Embodiment 1. That is, the susceptor 1 which includes the at least one pocket 2 in accordance with Embodiment 1 can further include a pocket in which the supporting portion, the contact portion, and the non-contact portion are provided in a conventional number and in a conventional arrangement. The present invention therefore also encompasses, as an embodiment, a susceptor including a plurality of pockets 2 in which wafers 10 are to be respectively placed, at least one of the pockets 2 including supporting portions 3, contact portions 4 and non-contact portions 5 which are configured as described above.

The susceptor in accordance with an embodiment of the present invention is used in manufacturing semiconductors. A semiconductor manufacturing device at least includes: a chamber having an exhaust port; a susceptor accommodated in the chamber; a source gas supply device for supplying a source gas into the chamber; a carrier gas supply device for supplying a carrier gas into the chamber; a rotation device for rotating the susceptor; and a chamber heating device for heating an inside of the chamber. In the semiconductor manufacturing device, thin-film crystalline layers are formed and stacked on a surface of a wafer placed on the susceptor while the susceptor is rotated, and thus a semiconductor is manufactured. That is, the semiconductor is manufactured by a method in which the susceptor is rotated, the wafer placed on the susceptor is heated, and thin film crystalline layers are formed and stacked on the surface of the wafer.

The wafer which has been subjected to various processes by the manufacturing device is made into a chip, then packaged (as a module) into a semiconductor device to be incorporated in, for example, a variety of products such as LEDs.

### Embodiment 2

The following description will discuss another embodiment of the present invention. Note that, for convenience of explanation, members identical in function to those described in Embodiment 1 are given identical reference numerals, and descriptions of such members are omitted.

The supporting portions 3, the contact portions 4, and the non-contact portions 5 described in Embodiment 1 do not need to be provided at equal intervals in the pocket 2 (e.g., so as to be line-symmetric or point-symmetric when the pocket 2 is viewed from above). That is, the number, arrangement, and size (length) thereof are appropriately set so that conductive heat can be uniformly applied to the wafer 10 in accordance with a position of the pocket 2 in the susceptor 1, a position of the heating device, and the like. Therefore, in a case where a plurality of pockets 2 are provided in the susceptor 1, the number, arrangement, and size (length) of the supporting portions 3, the contact portions 4, and the non-contact portions 5 can vary in different pockets 2.

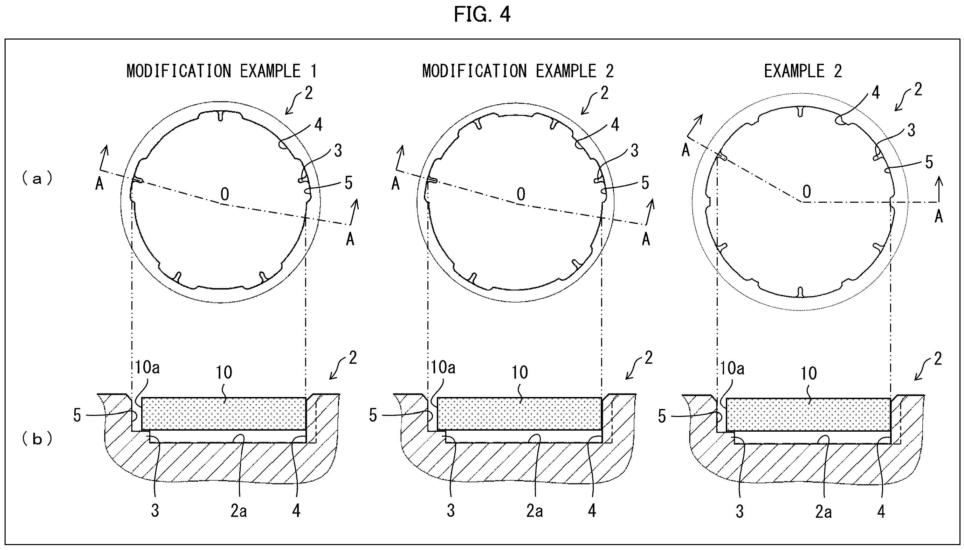

Specifically, the pocket 2 (Example 1 illustrated in Fig. 2), in which six (even number) supporting portions 3, six (even number) contact portions 4, and six (even number) non-contact portions 5 are equally spaced, is merely an example used to describe Embodiment 1. According to other embodiments of the present invention, as modification examples (patterns) of the above pocket 2, for example, the pocket 2 can include five (odd number) supporting portions 3, five (odd number) contact portions 4, and five (odd number) non-contact portions 5 (Modification Example 1), the pocket 2 can include six supporting portions 3, six contact portions 4, and six non-contact portions 5 which are arranged at unequal intervals (Modification Example 2), and the like (see Fig. 4).

### Examples

The following description will discuss the susceptor in accordance with the present invention in greater detail with reference to Examples and Comparative Examples. Note, however, that the present invention is not limited only to Examples in accordance with the present invention.

### [Example 1]

In a susceptor, the pocket 2 illustrated in (a) and (b) of Fig. 2 was provided as Example 1 which was an independently formed pocket. Specifically, the susceptor as follows was prepared: a surface of high-purity isotropic graphite was coated with SiC; a diameter (φ) of the pocket 2 was 50 mm; the pocket 2 included six supporting portions 3; six non-contact portions 5 were provided in the inner peripheral wall of the pocket 2 at respective positions which were adjacent to positions at which the supporting portions 3 were provided; six contact portions 4, each of which had a length of 13 mm (in the circumferential direction when the pocket is viewed from above), were provided between the non-contact portions 5; and a total length of the contact portions 4 in the circumferential direction accounted for approximately 50% of a circumference. Then, a semiconductor was manufactured with used of the susceptor on which a wafer 10 was placed in the pocket 2 as illustrated in (b) of Fig. 2.

### [Example 2]

As Example 2, a susceptor was prepared in a manner similar to that of Example 1 except that the diameter (φ) of the pocket 2 was set to 200 mm and the length of each contact portion 4 was set to 2 mm as illustrated in (a) and (b) of Fig. 4 and, in the susceptor thus prepared, a total length of the contact portions 4 in the circumferential direction accounted for approximately 1.9% of the circumference. With use of the susceptor, a semiconductor was manufactured.

### [Comparative Example 1]

In a susceptor, a pocket 2' illustrated in (a) of Fig. 2 was prepared as Comparative Example 1 which was an independently formed pocket. Specifically, the susceptor as follows was prepared: a surface of high-purity isotropic graphite was coated with SiC; the pocket 2' included six supporting portions 3'; six contact portions 4', each of which had a length of 1 mm (in the circumferential direction when the pocket is viewed from above), were provided in the inner peripheral wall of the pocket 2' at respective positions which were adjacent to positions at which the supporting portions 3' were provided; and six non-contact portions 5' were provided between the contact portions 4'. Then, a semiconductor was manufactured with used of the susceptor in which a wafer 10 was placed in the pocket 2' as illustrated in (b) of Fig. 2.

### [Comparative Example 2]

In a susceptor, a pocket 2" illustrated in (a) of Fig. 2 was prepared as Comparative Example 2 which was an independently formed pocket. Specifically, the susceptor as follows was prepared: a surface of high-purity isotropic graphite was coated with SiC; the pocket 2" included six supporting portions 3"; and a contact portion 4" was provided in a whole circumference of an inner peripheral wall of the pocket 2". Then, a semiconductor was manufactured with used of the susceptor in which a wafer 10 was placed in the pocket 2" as illustrated in (b) of Fig. 2.

### (Results)

As compared with the susceptor of Comparative Example 1, a life of the susceptor of Example 1 was doubled. Further, a yield of semiconductor chips manufactured from wafers was improved by 10%.

The life of the susceptor of Example 1 was equivalent to that of the susceptor of Comparative Example 2 but the yield of semiconductor chips manufactured from wafers was improved by 20% as compared with Comparative Example 2.

As compared with the susceptor of Comparative Example 1, a life of the susceptor of Example 2 was doubled. Further, a yield of semiconductor chips manufactured from wafers was improved by 15%.

The life of the susceptor of Example 2 was equivalent to that of the susceptor of Comparative Example 2 but the yield of semiconductor chips manufactured from wafers was improved by 25% as compared with Comparative Example 2.

In the susceptor of Comparative Example 1, the length of the one contact portion 4' is short, i.e., 1 mm, and the contact portion 4' is provided in areas where the supporting portions 3' are provided. Therefore, conductive heat is easily applied locally to the wafer 10. Accordingly, a temperature difference occurred in the wafer 10 between the outer peripheral portion which is in contact with the pocket 2' and the central portion which is not in contact with the pocket 2', and this led to the lower yield of semiconductor chips. Further, since the length of the one contact portion 4' is short, i.e., 1 mm, the stress caused by centrifugal force was concentrated on the contact portion 4' when the susceptor was rotated during various processes, and chipping was easily caused in the susceptor and the wafer 10.

In the susceptor of Comparative Example 2, the contact portion 4" is provided in the whole circumference of the inner peripheral wall of the pocket 2". Therefore, conductive heat is applied more over the whole circumference of the wafer 10, and conductive heat from the supporting portions 3" is also applied in the vicinity of the supporting portions 3". Accordingly, a greater temperature difference occurred in the wafer 10 between the outer peripheral portion which is in contact with the pocket 2" and the central portion which is not in contact with the pocket 2", and this led to the lower yield of semiconductor chips.

### Industrial Applicability

The susceptor in accordance with the present invention can be widely used in manufacturing semicond uctors.

### Reference Signs List

1: Susceptor
2: Pocket
3: Supporting portion
4: Contact portion
5: Non-contact portion
10: Wafer

## Claims

1. A susceptor comprising at least one pocket in which a wafer is to be placed, wherein:
the at least one pocket includes a plurality of supporting portions which is to support a wafer, a plurality of contact portions which are to make contact with a lateral surface of the wafer, and a plurality of non-contact portions which are not to make contact with the lateral surface of the wafer;
the plurality of contact portions and the plurality of non-contact portions are alternately provided in an inner peripheral wall of the at least one pocket; and
at least two of the plurality of supporting portions are respectively disposed on lines extending from a center of the at least one pocket to the plurality of non-contact portions when the susceptor is seen from above.

2. The susceptor as set forth in claim 1, wherein a length of each of the plurality of contact portions is 2 mm or more in a circumferential direction.

3. The susceptor as set forth in claim 1 or 2, wherein a total length of the plurality of contact portions in the circumferential direction accounts for 1.5% to 50% of a circumference of the at least one pocket.
